# EUROPEAN PATENT APPLICATION

(11) **EP 1 783 507 A1**
(43) Date of publication of application: **09.05.2007**
(21) Application number: 06729389.4
(22) Date of filing: 17.03.2006
(51) Int. Cl.: G01R 33/09, G01C 17/28

(54) **MAGNETIC FIELD DETECTING APPARATUS AND ELECTRONIC COMPASS USING THE SAME**

(30) Priority: 24.03.2005 JP 2005086292
(71) Applicant: ALPS ELECTRIC CO., LTD., Tokyo 145-8501 (JP)
(72) Inventor: FUSE, Masashi, cho, Ota-ku, Tokyo, 1458501 (JP)
(74) Representative: Klunker . Schmitt-Nilson . Hirsch
(86) International application number: PCT/JP2006/005400
(87) International publication number: WO 2006/101050

(57) **Abstract**

[Object] To provide a magnetic sensing device that can obtain the strength of an external magnetic field under circumstances where a relatively strong disturbance takes place, and an electronic compass using the same.

[Solving Means] A current c supplied to a coil 112 and its current deviation x are set. The current c, current c+x, and current cx are supplied to the coil 112 to generate AC magnetic fields, which are then applied to MR elements 111, and voltages V₀ to V₂ are detected. Using the voltages V₀ to V₂ detected by the voltage detector 13, an amplitude determining unit 14 determines whether the magnetic field is outside a sensing range of the MR elements 111. When the magnetic field is outside the sensing range of the MR elements 111, an amplitude controller 17 increases the current deviation x, and the current amplifier 18 supplies current using the current deviation newly set by the amplitude controller 17 to the coil 112. In this manner, the slope of the MR elements 111 is detected.

## Description

### Technical Field

The present invention relates to a magnetic sensing device and an electronic compass using the same.

### Background Art

To electronically measure the azimuth, a magnetic sensor that detects an external magnetic field such as the geomagnetic field is used. To measure the azimuth using a magnetic sensing circuit including the magnetic sensor, a known technique involves applying an AC magnetic field to the magnetic sensor and using a voltage output from the magnetic sensor in response to the application of the AC magnetic field.

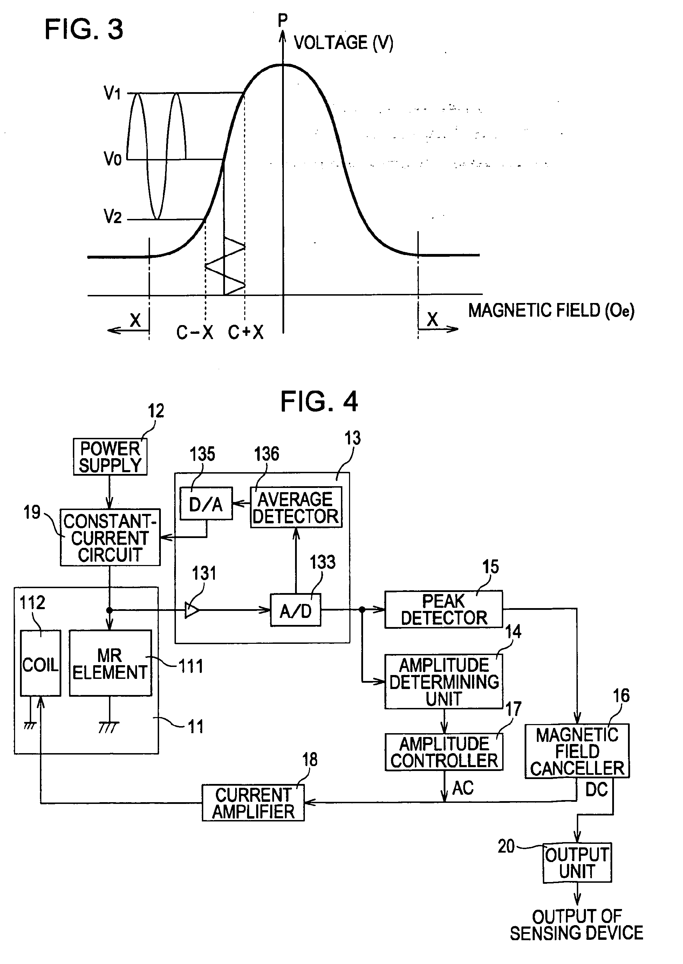

This technique uses the magnetic sensor including a magnetoresistive element whose internal resistance changes in response to application of a magnetic field. The magnetoresistive element shows, as shown in Fig. 3, symmetrical changes in resistance with respect to the magnetic field. In response to application of an external magnetic field such as the geomagnetic field, the operating point of the magnetoresistive element on the characteristic curve shown in Fig. 3 is shifted left or right. At this point, the operating point of the magnetoresistive element is in a sloping region (linear region, e.g., at position C) of the characteristic curve. When an AC magnetic field is superimposed on this magnetoresistive element, a change in resistance can be detected using the characteristics of the magnetoresistive element. A current for canceling out the external magnetic field is then applied to move the operating point to the peak position shown in Fig. 3, and this current corresponding to the external magnetic field can be measured. From this current value, the strength of the external magnetic field can be obtained.

Non-Patent Document 1: APPLICATION NOTE "Electronic Compass Design using KMZ51 and KMZ52", AN00022, Philips Semiconductors

### Disclosure of Invention

### Problems to be Solved by the Invention

In the above-described technique, however, when a relatively strong disturbance, e.g., a disturbance caused by a loudspeaker of a cellular phone, is applied to the magnetoresistive element, that is, when the operating point of the magnetoresistive element on the characteristic curve is greatly shifted left or right, the operating point of the magnetoresistive element is moved to a planar region of the characteristic curve, which is the state where there is no change in resistance. This state is outside the sensing range of the magnetoresistive element. In the magnetic sensing device, however, it becomes impossible to determine whether there is no change in resistance because the external magnetic field is cancelled out or because the operating point is outside the sensing range. As has been described above, the strength of the external magnetic field cannot be measured under circumstances where there is such a relatively strong disturbance.

In view of this point, it is an object of the present invention to provide a magnetic sensing device that can measure the strength of an external magnetic field under circumstances where a relatively strong disturbance takes place, and an electronic compass using the same.

### Means for Solving the Problems

A magnetic sensing device of the present invention includes a magnetic sensor that detects a magnetic field from a change in resistance; magnetic field generating means for applying an AC magnetic field to the magnetic sensor; determining means for determining, on the basis of an output voltage corresponding to the applied AC magnetic field, whether the magnetic field is outside a sensing range of the magnetic sensor; amplitude controlling means for controlling the amplitude of the AC magnetic field when the magnetic field is not within the sensing range of the magnetic sensor; magnetic field canceling means for supplying a DC current for canceling out an external magnetic field to be sensed, which is superimposed on the magnetic sensor, to the magnetic field generating means; and output means for obtaining the strength of the external magnetic field from the DC current value and outputting the strength.

With this structure, whether the magnetic field is outside the sensing range of the magnetic sensor is determined. When the magnetic field is not within the sensing range of the magnetic sensor, the amplitude of the AC magnetic field is controlled, that is, feedback control is performed so that the slope of the characteristic curve of the magnetic sensor can be detected. In doing so, a change in resistance, which is the characteristic of the magnetic sensor, can be used. Therefore, magnetic field sensing can be performed even under circumstances where a relatively large disturbance occurs.

According to the magnetic sensing device of the present invention, the magnetic field generating means preferably includes a coil. Preferably, the AC magnetic field is applied to the magnetic sensor by supplying current to the coil, and the amplitude controlling means preferably controls the amplitude of the AC magnetic field by changing a current deviation of the current supplied to the coil.

According to the magnetic sensing device of the present invention, the determining means preferably performs determination using a first voltage obtained when a specific current is supplied to the coil, a second voltage obtained when a current obtained by subtracting the current deviation from the specific current is supplied to the coil, and a third voltage obtained when a current obtained by adding the current deviation to the specific current is supplied to the coil. In this case, the determining means preferably determines that the magnetic field is outside the sensing range of the magnetic sensor when the first to third voltages are approximately equal.

With this structure, it is reliably detected that the magnetic field is in a planar region of the characteristic curve of the magnetic sensor, that is, the magnetic field is outside the sensing range. Therefore, this state can be distinguished from a state of no slope meaning that the magnetic field is cancelled out. This allows transition to feedback control for detecting the slope.

According to the magnetic sensing device of the present invention, the magnetic field canceling means preferably determines that the magnetic field is cancelled out when the first voltage is greater than the second and third voltages, and when the second voltage and the third voltage are approximately equal.

With this structure, unlike in normal magnetic field sensing, the condition using the first voltage serving as the specific voltage (operating point) is used. It is thus possible to reliably detect the peak of the characteristic curve, meaning that the magnetic field is cancelled out. Accordingly, a state of no slope outside the sensing range of the magnetic sensor can be distinguished.

According to the magnetic sensing device of the present invention, the magnetic sensor is preferably a magnetoresistive element that exhibits symmetrical changes in resistance with respect to a magnetic field.

According to the magnetic sensing device of the present invention, it is preferable that the magnetic sensing device further include a constant-current circuit that supplies a current having a predetermined preset value to the magnetoresistive element, and current-preset-value controlling means for controlling the preset value so that a terminal voltage of the magnetoresistive element is approximately constant.

With this structure, feedback control of the current preset value is performed on the basis of the terminal voltage. This reduces the effect of variations in resistance of the magnetoresistive element or temperature changes. Therefore, a single magnetoresistive element can accurately perform magnetic field sensing. As a result, the structure of the magnetic sensing device can be simplified.

According to the magnetic sensing device of the present invention, the magnetoresistive element is preferably a GIG element or an MR element.

An electronic compass of the present invention includes a plurality of magnetic sensing devices as described above, and azimuth calculating means for obtaining an azimuth using output values obtained by the plurality of magnetic sensing devices.

With this structure, the electronic compass includes the magnetic sensing devices, each of which performs feedback control using the first to third voltages V₀ to V₂ to determine whether the magnetic field is outside the sensing range of the magnetic sensor, and, when the magnetic field is not within the sensing range of the magnetic sensor, performs feedback control of the amplitude of the AC magnetic field. Even under circumstances where a relatively large disturbance occurs, the azimuth can be obtained. Advantages of the Invention

According to the present invention, whether a magnetic field is outside a sensing range of a magnetic sensor is determined on the basis of an output voltage corresponding to an applied AC magnetic field. When the magnetic field is not within the sensing range of the magnetic sensor, the amplitude of the AC magnetic field is controlled. Even under circumstances where a relatively large disturbance occurs, a change in resistance, which is the characteristic of the magnetic sensor, can be used to perform magnetic field sensing.

### Best Mode for Carrying Out the Invention

Embodiments of the present invention will be described in detail with reference to the accompanying drawings.

### (First Embodiment)

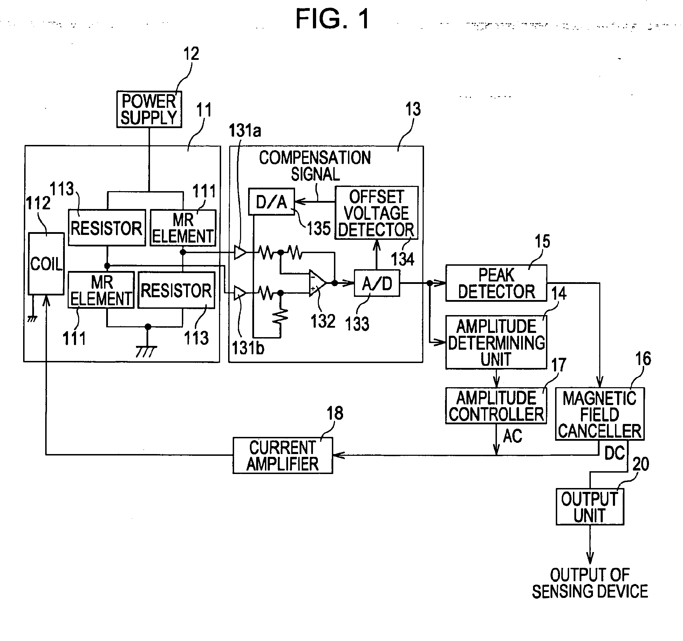

Fig. 1 is a block diagram showing the schematic structure of a magnetic sensing device according to a first embodiment of the present invention. The main components of the magnetic sensing device include a magnetic sensor 11 that senses a magnetic field; a power supply 12 that applies a power supply voltage to the magnetic sensor 11; a voltage detector 13 that detects a voltage output from the magnetic sensor 11 in response to application of an AC magnetic field to the magnetic sensor 11; an amplitude determining unit 14 that determines whether the magnetic field is outside a sensing range of the magnetic sensor 11 on the basis of the amplitude of the voltage corresponding to the AC magnetic field applied to the magnetic sensor 11; a peak detector 15 that detects the peak of the voltage on the basis of the voltage corresponding to the AC magnetic field applied to the magnetic sensor 11; a magnetic field canceller 16 that supplies a DC current for canceling out an external magnetic field applied to the magnetic sensor 11 to a magnetic field generator; an amplitude controller 17 that controls the amplitude of the AC magnetic field on the basis of the determination result obtained by the amplitude determining unit 14; a current amplifier 18 that amplifies a current for generating the AC magnetic field applied to the magnetic sensor 11; and an output unit 20 that obtains the strength of the external magnetic field from the DC current value for canceling out the magnetic field and outputs the strength.

The magnetic sensor 11 includes MR (MagnetoResistance) elements 111, serving as magnetoresistive elements exhibiting symmetrical changes in resistance with respect to a magnetic field, and a coil 112 that applies an external magnetic field to the MR elements 111. Alternatively, instead of the MR elements 111, GIG (Granular In Gap) elements that can sense the geomagnetic field with relatively better sensitivity may be used as the magnetoresistive elements. In the magnetic sensor 11, as shown in Fig. 1, the two MR elements 111 are bridge-connected to two resistors 113 having a temperature coefficient of resistance equivalent to that of the MR elements. With this bridge connection, changes in resistance of the MR elements 111 with temperature are cancelled out, and the voltage output to the voltage detector 13 can be doubled.

The power supply 12 applies a power supply voltage to the MR elements 111. As shown in Fig. 3, the voltage detector 13 extracts a change in resistance of the MR elements 111 to which an AC magnetic field 22 is applied in the form of voltage. The voltage detector 13 includes buffer amplifiers 131a and 131b, a differential amplifier 132, an A/D converter 133, an offset voltage detector 134, and a D/A converter 135. Voltages across the MR elements 111 are impedance-converted by the buffer amplifiers 131a and 131b, the difference of which is obtained by the differential amplifier 132. This difference is converted by the A/D converter 133 into a digital signal, and, on the basis of the difference (unbalance at the bridge: offset voltage), the offset voltage detector 134 obtains a compensation value. This compensation value is converted by the D/A converter 135 into a compensation voltage, which is then delivered as a feedback to the differential amplifier 132. With this structure, unbalance due to the bridge connection in the magnetic sensor 11 can be corrected.

The voltage detected by the voltage detector 13 is sent to the amplitude determining unit 14 and the peak detector 15. In the voltage detector 13, a first voltage (V₀) in response to supply of a specific current c to the coil 112, a second voltage (V₁) in response to supply of current cx to the coil 112, which is the current obtained by subtracting a current deviation x from the specific current c, and a third voltage (V₃) in response to supply of current c+x to the coil 112, which is the current obtained by adding the current deviation x to the specific current c, are detected. The first to third voltages are sent to the amplitude determining unit 14.

The amplitude determining unit 14 determines whether the magnetic field is outside the sensing range of the magnetic sensor 11 on the basis of the voltages corresponding to magnetic fields applied to the magnetic sensor 11. As shown in Fig. 3, the amplitude determining unit 14 uses the first to third voltages (V₀ to V₂) detected by the voltage detector 13 to perform the determination. As in a known magnetic sensing device, the slope of a characteristic curve shown in Fig. 3 can be detected by obtaining the second voltage V₂ and the third voltage V₃. However, it is necessary to use the first voltage V₀ in order to determine whether the magnetic field is within the sensing range of the MR elements 111. As shown in Fig. 3, the slope of the characteristic curve is zero at the peak P of the characteristic curve and in planar regions X. That is, the slope is zero when the magnetic field is cancelled out, and the slope is also zero when the magnetic field is outside the sensing range of the MR elements 111. Under circumstances where a relatively strong disturbance takes place, it is impossible to determine whether the magnetic field is cancelled out, that is, the magnetic field is in a state at the peak P shown in Fig. 3, or the magnetic field is outside the sensing range of the MR elements 111 (planar region X). To solve this problem, as has been described above, the first to third voltages (V₀ to V₂) are used to determine whether the magnetic field is outside the sensing range of the MR elements 111. Specifically, when the first, second, and third voltages V₀, V₁, and V₂ are approximately equal, that is, when V₀ ≈ V₁ ≈ V₂, the amplitude determining unit 14 determines that the magnetic field is in the planar region X shown in Fig. 3. Thus, the amplitude determining unit 14 determines that the magnetic field is outside the sensing range of the MR elements 111. The phrase "approximately equal" means that the difference is less than or equal to about 1 mV. The determination result is sent to the amplitude controller 17. With these conditions, whether the magnetic field is in the planar region X of the characteristic curve of the MR elements 111, that is, whether the magnetic field is outside the sensing range, can be reliably determined. Therefore, this state can be distinguished from a state of no slope meaning that the magnetic field is cancelled out. This allows transition to feedback control for detecting the slope.

The peak detector 15 detects the peak P of the characteristic curve shown in Fig. 3 on the basis of the voltages sent from the voltage detector 13. The magnetic field canceller 16 cancels out the external magnetic field applied to the magnetic sensor 11. The state in which the external magnetic field is cancelled out is the state at the peak P of the characteristic curve shown in Fig. 3. To determine the position of the peak P, as has been described above, the amplitude determining unit 14 determines the amplitude using the first to third voltages (V₀ to V₂) detected by the voltage detector 13. In this case, the conditions are such that the first voltage V₀ is greater than the second voltage V₁ and the third voltage V₂, and that the second voltage V₁ and the third voltage V₂ are approximately equal, that is, V₀ > V₁, V₂ (expression 1), and V₁ ≈ V₂ (expression 2). The phrase "approximately equal" means that the difference is less than or equal to about 1 mV. When the magnetic field is not cancelled out, that is, when one of the two expressions is not satisfied, a control signal (DC component) proportional to V₁V₂ is sent to the current amplifier 18 described later, thereby controlling the current c supplied to the coil 112. In this state, the control amount is corrected by repeatedly performing control of the current c and detection of V₁V₂. When it is determined that the magnetic field is cancelled out, the current C corresponding to the external magnetic field is detected. From this current, the strength of the external magnetic field is obtained, and the strength is output as the output of the sensing device (external magnetic field strength) from the output unit 20. In this manner, unlike in normal magnetic field sensing, with the condition using the first voltage V₀ serving as the specific voltage (operating point), the peak of the characteristic curve, which means that the magnetic field is cancelled out, can be reliably determined. This can thus be distinguished from a state of no slope outside the sensing range of the MR elements 111.

The amplitude controller 17 controls the amplitude of the AC magnetic field on the basis of the determination result obtained by the amplitude determining unit 14. When the amplitude determining unit 14 determines that the magnetic field is outside the sensing range of the MR elements 111, the amplitude controller 17 increases the amplitude of the AC magnetic field applied to the MR elements 111 such that the slope of changes in resistance is detectable. Thereafter, the amplitude determining unit 14 performs the determination again on the basis of a voltage obtained from the AC magnetic field whose amplitude has been increased. There is no restriction on the degree of increasing the amplitude. However, when the amplitude is increased at one time reaching the opposite quadrant of the characteristic curve shown in Fig. 3 (right quadrant shown in Fig. 3), a voltage increase may be overlooked, which is not preferable. Specifically, the amplitude of the AC magnetic field is controlled by stepwisely changing the current deviation x of current supplied to the coil 112 while checking the detection state.

The current amplifier 18 amplifies current for generating the AC.magnetic field applied to the MR elements 111 and supplies the amplified current to the coil 112. The current amplifier 18 and the coil 112 constitute magnetic field generating means. Accordingly, the AC magnetic field can be applied to the MR elements 111. Using the characteristics of magnetoresistive elements, the slope of changes in resistance can be detected on the basis of the changes in resistance. The larger the number of turns of the coil 112, the smaller the power supply current. As a result, the power consumption of the circuit can be reduced. The current amplifier 18 changes the current c supplied to the coil 112 when it is determined that the magnetic field is not cancelled out on the basis of the determination result obtained by the magnetic field canceller 16. Whether the magnetic field is cancelled out is determined using the voltages of the MR elements 111 to which the AC magnetic field based on the newly set current is applied.

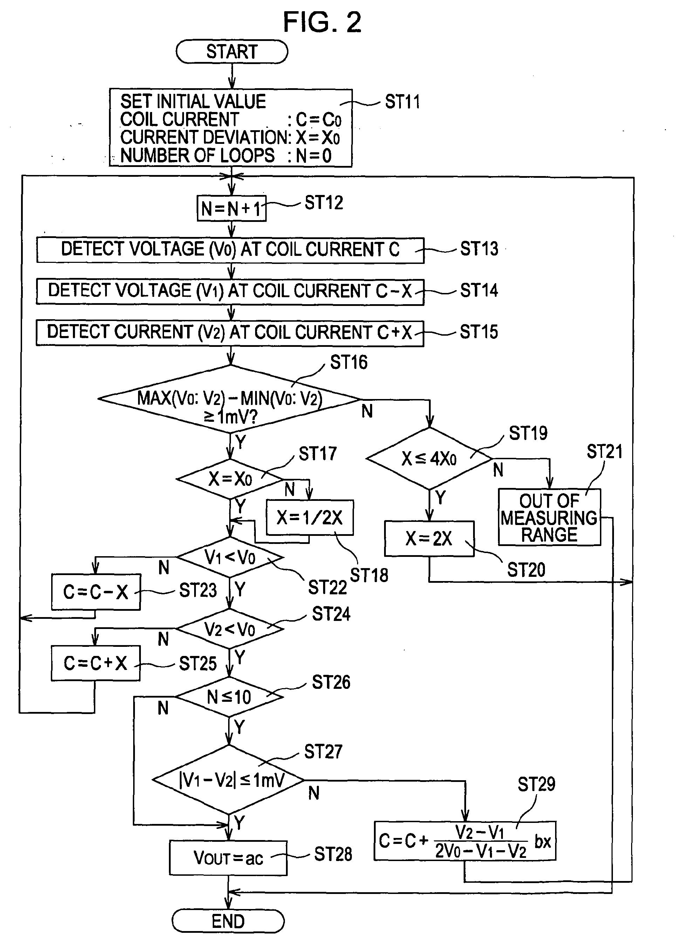

The operation of the magnetic sensing device with the above-described structure will now be described. Fig. 2 is a flowchart describing the sensing operation of the magnetic sensing device according to the first embodiment of the present invention. At first, the current c = c₀ to be supplied to the coil 112, its current deviation (amplitude) x = x₀, and the number of loops N = 0 are set (ST11). These preset values may be set as default, or may be input as needed.

The number of loops is incremented by one (ST12), and the current c is supplied to the coil 112 to generate an AC magnetic field, which is then applied to the MR elements 111. At this point, the voltage detector 13 detects a change in resistance as the voltage V₀ (ST13). The power supply voltage is applied from the power supply 12 to the MR elements 111. Next, the current cx is supplied to the coil 112 to generate an AC magnetic field, which is then applied to the MR elements 111. At this point, the voltage detector 13 detects a change in resistance as the voltage V₁ (ST14). The current c+x is supplied to the coil 112 to generate an AC magnetic field, which is then applied to the MR elements 111. At this point, the voltage detector 13 detects a change in resistance as the voltage V₂ (ST15). ST13 to ST15 may not necessarily be performed in this order. These voltages V₀ to V₂ may be appropriately detected in a different order.

Using the first to third voltages V₀, V₁, and V₂ detected by the voltage detector 13, the amplitude determining unit 14 determines whether the magnetic field is outside the sensing range of the MR elements 111. Specifically, the following process is performed. In this case, the maximum current deviation is set to 8x₀. The current deviation x becomes 8x₀ in the case of the fourth loops. Thus, the amplitude determining unit 14 determines whether the differential voltage obtained by subtracting the minimum value of V₀:V₂ from the maximum value of V₀:V₂ is less than or equal to 1 mV (ST16). When the differential voltage is less than 1 mV, the amplitude determining unit 14 determines whether the current deviation is less than or equal to 4x₀ (ST19). When the differential voltage is less than 1 mV and the current deviation is greater than or equal to 4x₀, the magnetic field is regarded to be within the planar region of the characteristic curve shown in Fig. 3. It is thus determined that the magnetic field is outside the measuring range (ST21), and the process is ended. When the differential voltage is less than 1 mV and the current deviation is less than or equal to 4x₀, the amplitude determining unit 14 sends a control signal indicating that to the amplitude controller 17, and the amplitude controller 17 doubles the current deviation (ST20). Control information thereof is sent to the current amplifier 18, and the current amplifier 18 supplies current using the corrected current deviation to the coil 112. The number of loops is incremented by one (ST12), and then the voltage detecting steps (ST13 to ST15) are performed. In contrast, when the differential voltage is greater than or equal to 1 mV, it is determined whether the current deviation x is the initial value, that is, whether x = x₀ (ST17). If the current deviation x is not the initial value, the current deviation x is halved (ST18). With such feedback control, the slope of the characteristic curve of the MR elements 111 is detected. To cancel out the magnetic field in a short period of time to obtain Vₒᵤₜ serving as the output of the sensing device, it is preferable to use the previously measured value c as the initial value c₀ of the coil current c. If magnetic disturbance fluctuations are intense, the current value C does not converge, and the peak P of the characteristic curve of the MR elements 111 cannot be detected. In such a case, it may be regarded that it is impossible to perform detection, and the control operation may be terminated. For example, the detection time or the number of loops may be determined in advance, and, when the predetermined detection time or the number or loops is exceeded, the control operation may be terminated.

When the slope of the MR elements 111 is detected by the above-described feedback control, the external magnetic field superimposed on the MR elements 111 is canceled out. Whether the magnetic field is cancelled out is determined using the first to third voltages V₀, V₁, and V₂ detected by the voltage detector 13. That is, it is determined whether the condition V₀ > V₁, V₂ and the condition V₁ ≈ V₂ are satisfied. Specifically, it is determined whether V₁ is less than V₀ (ST22). If V₁ is less than V₀, it is then determined whether V₂ is less than V₀ (ST24). ST22 may be performed prior to ST24 and vice versa. When V₁ is greater than or equal to V₀, the current c is changed to the current cx (ST23), the number of loops is incremented by one (ST12), and the voltage detecting steps (ST13 to ST15) are performed. When V₂ is greater than or equal to V₀, the current c is changed to the current c+x (ST25), the number of loops is incremented by one (ST12), and the voltage detecting steps (ST13 to ST15) are performed. When V₁ is less than V₀ and when V₂ is less than V₀, it is determined whether the number of loops is less than or equal to ten (ST26). When the number of loops is less than or equal to ten, it is determined whether the difference between V₁ and V₂ is less than or equal to 1 mV, that is, whether V₁ and V₂ are approximately equal (ST27). When this condition is satisfied, a current obtained when the magnetic field is cancelled out is a value corresponding to the external magnetic field. Thus, the coil current c is adjusted by a value proportional to (V₂V₁)/(2V₀V₁V₂), thereby canceling out the magnetic field. That is, the output voltage Vₒᵤₜ of the magnetic sensing device = ac (a: sensitivity coefficient) is obtained (ST28). In contrast, when the difference between V₁ and V₂ is not less than or equal to 1 mV, the current amplifier 18 changes the current c to c+{(V₂V₁)/(2V₀V₁V₂)} ·bx (b: constant of proportion) on the basis of the control signal (DC component) from the magnetic field canceller 16 (ST29), the number of loops is incremented by one (ST12), and the voltage detecting steps (ST13 to ST15) are performed. This feedback control is repeatedly performed until the magnetic field is cancelled out. As in the above manner, the output voltage of the voltage sensing device is obtained (ST28). If the number of loops exceeds ten, it is regarded that the above conditions (V₀ > V₁, V₂ and V₁ ≈ V₂) are satisfied, and the output voltage of the magnetic sensing device is obtained (ST28). The number of loops, the change rate of the current deviation, the value V₂V₁, and the like are not limited to those described in the embodiment and may be changed where appropriate. For example, when fluctuations in the external magnetic field with time are small, the constant of proportion b is appropriately set such that the value V₂V₁ is reduced to about one-third every time the number of loops is incremented by one.

In this manner, in the magnetic sensing device according to the embodiment, feedback control is performed using the first to third voltages V₀ to V₂ to determine whether the magnetic field is outside the sensing range of the MR elements 111. If the magnetic field is not within the sensing range of the magnetic sensor, the amplitude of the AC magnetic field is controlled, that is, the feedback control is performed such that the slope can be detected. In doing so, changes in resistance serving as the characteristic of the MR elements 111 can be employed. Even under circumstances where a relatively strong disturbance takes place, magnetic field sensing can be performed.

In a magnetic sensing method according to the embodiment, the slope is detected by performing the feedback control, and it is determined whether the magnetic field is cancelled out using the above expressions 1 and 2. Even when the peak of the characteristic curve of a magnetoresistive element such as a MR element is not clear or, provided that the peak is clear, the sensing range is narrow (meaning high sensitivity), the external magnetic field can be accurately detected.

### (Second Embodiment)

In this embodiment, the case in which there is only one MR element 111 will be described. Fig. 4 is a block diagram showing the schematic structure of a magnetic sensing device according to the second embodiment of the present invention. In Fig. 4, the same reference numerals are given to the same components as those shown in Fig. 1, and detailed descriptions thereof are omitted.

The magnetic sensing device shown in Fig. 4 includes a constant-current circuit 19 that supplies a predetermined current to the MR element 111. In this magnetic sensing device, the magnetic sensor 11 includes the single MR element 111 and the coil 112. In this magnetic sensing device, the voltage detector 13 includes a buffer amplifier 131, the A/D converter 133, an average detector 136 serving as current-preset-value controlling means for controlling the predetermined current so that the current is approximately constant on the basis of the terminal voltage of the MR element 111, and the D/A converter 135. A current mirror circuit, which is a CMOS analog circuit that can achieve high impedance using a low power supply voltage, may be used as the constant-current circuit 19.

In this magnetic sensing device, the average detector 136 detects the terminal voltage of the MR element 111 at high impedance using a buffer circuit with an operational amplifier or a noninverting amplifier circuit. The average detector 136 obtains the average of terminal voltages and performs feedback control of the current preset value of the constant-current circuit 19. Specifically, when the MR element 111 exhibits high resistance, the constant-current circuit 19 is controlled such that current is allowed to flow all the time regardless of the sensing operation of the magnetic sensor. This reduces the effect of delay time, due to the effect of stray capacitance, from the supply of current to stabilizing of the terminal voltage. In contrast, when the MR element 111 exhibits low resistance, the constant-current circuit 19 is controlled such that current is allowed to flow only during magnetic field sensing. In this case, the current preset value of the constant-current circuit 19 is appropriately determined by referring to the current preset value during the previous magnetic field sensing. With such feedback control of the current preset value based on the terminal voltage, the effect of variations in resistance of the MR element 111 or changes in resistance of the MR element due to temperature changes on the sensing function of the magnetic sensing device can be reduced. Therefore, accurate magnetic field sensing can be done using the single MR element 111. As a result, the structure of the magnetic sensing device can be simplified. Even in the case where the resistance of the MR element 111 varies greatly or the aging of resistance or the temperature change is great, measurement can be done without any adjustment.

In this structure, an additional mechanism for monitoring the operating state of the current amplifier 18 and the coil 112 serving as the magnetic field generating means may be provided. After the magnetic field generating means reaches a constant current state, the voltage detector 13 may measure the terminal voltage of the MR element 111. In this way, delay in current increasing speeds caused by using a coil with a large inductance can be minimized.

In this magnetic sensing device, the current c supplied to the coil 112 and its current-deviation x are set. The current c, the current c+x, and the current cx are each supplied to the coil 112 to generate an AC magnetic field, which is then applied to the MR element 111, and the first to third voltages V₀ to V₂ are detected. Next, the amplitude determining unit 14 determines, using the first to third voltages V₀ to V₂ detected by the voltage detector 13, whether the magnetic field is outside the sensing range of the MR element 111. If the magnetic field is outside the sensing range of the MR element 111, the amplitude controller 17 increases the current deviation x, and the current amplifier 18 supplies current using the current deviation newly set by the amplitude controller 17 to the coil 112. In this way, the slope of the MR element 111 is detected. Thereafter, the magnetic field is cancelled out, and the external magnetic field is obtained. Therefore, the magnetic sensing device according to this embodiment can employ changes in resistance serving as the characteristic of the MR element 111. Even under circumstances where a relatively strong disturbance takes place, magnetic field sensing can be performed.

When the magnetic sensing devices according to the first and second embodiments described above are constructed using an analog detection system, since the system is a temporary continuous detection system, a wide sensing range can be achieved and output signal responsiveness is high. Since the sensing accuracy depends on the current/magnetic conversion accuracy of the coil 112, but not on the MR elements 111, the sensing sensitivity shows weak temperature dependence. With the constant current drive of the coil 112, errors due to changes in resistance of the coil caused by changes in ambient temperature or changes in power supply voltage can be reduced. In contrast, when the magnetic sensing devices are constructed using a digital detection system, since the system is an intermittent detection system, the magnetic sensing circuit can be shared by the MR elements 111 in multi-sensing directions. Because the D/A conversion accuracy of a signal processing circuit determines the sensing accuracy, the sensing accuracy does not depend on the A/D conversion accuracy. For this reason, a small A/D converter can be used, resulting in reduction in size and power consumption of the device. Since the magnetic sensing circuit itself has an A/D conversion function, there is no error caused by an analog circuit prior to A/D conversion.

When the single MR element is used as in this embodiment, the output voltage can be increased. That is, in the case of a bridge connection using two MR elements, the power supply voltage applied to the MR elements is 1/2.Vdd. In contrast, in the case of the magnetic sensor having the single MR element according to this embodiment, a voltage approximately near Vdd can be applied to the MR element. With the same power supply voltage, the output voltage becomes larger than that in the case where the bridge-connected MR elements are used. Since the single MR element is used, the area occupied by the magnetic sensor can be reduced, resulting in reduction in power consumption and size of the circuit. Unlike in the case of bridge-connected MR sensors, a problem of unbalanced voltage at the bridge does not occur.

### (Third Embodiment)

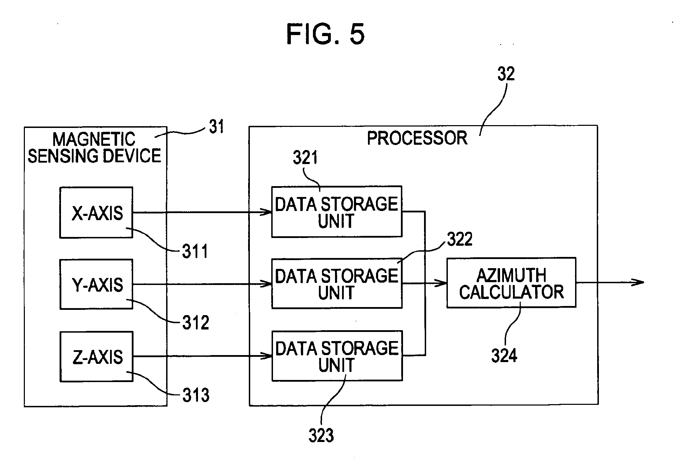

In this embodiment, an electronic compass using the magnetic sensing device according to the first or second embodiment will be described. Fig. 5 is a block diagram showing the schematic structure of the electronic compass using the magnetic sensing device according to the present invention.

The main components of the electronic compass shown in Fig. 5 include a magnetic sensing device 31 and a processor 32 that calculates the azimuth using the output voltages of the magnetic sensing device 31. The magnetic sensing device 31 includes an X-axis magnetic sensing circuit 311, a Y-axis magnetic sensing circuit 312, and a Z axis magnetic sensing circuit 313 with the structure according to the first or second embodiment. The processor 32 includes a data storage unit 321 that stores the output voltage output from the X-axis magnetic sensing circuit 311, a data storage unit 322 that stores the output voltage output from the Y-axis magnetic sensing circuit 312, a data storage unit 323 that stores the output voltage output from the Z-axis magnetic sensing circuit 313, and an azimuth calculator 324 that obtains the azimuth from these output voltages.

In the electronic compass with the above structure, the magnetic sensing device 31 uses the X-axis, Y-axis, and Z-axis magnetic sensing circuits 311 to 313 to measure an external magnetic field according to the first or second embodiment described above. The output voltages corresponding to the external magnetic field are stored in the data storage units 321 to 323, respectively. Thereafter, the azimuth calculator 324 uses the output voltages stored in the data storage units 321 to 323 to calculate the azimuth. That is, the azimuth is calculated by obtaining the arctangent of the ratio of the X-axis output voltage and the Y-axis output voltage. The Z-axis output voltage is used to correct the tilt state of the electronic compass. In this manner, the electronic compass according to this embodiment has the magnetic sensing device structured to determine whether the magnetic field is outside the sensing range of the MR element 111 by performing feedback control using the first to third voltages V₀ to V₂ and, when the magnetic field is not within the sensing range of the magnetic sensor, to perform feedback control of the amplitude of the AC magnetic field. Even under circumstances where a relatively strong disturbance takes place, the azimuth can be obtained.

In the electronic compass according to this embodiment, the output voltages corresponding to the axes are stored in the data storage units 321 to 323, respectively. Because the magnetic sensing circuits 311 to 313 use the stored output voltages to sense a magnetic field, the convergence time in the feedback control is reduced, resulting in reduction in the detection time. As a result, the overall power consumption of the electronic compass can be reduced.

To switch on or off the magnetic sensing circuits 311 and 313 using a CMOS analog switch, as in the second embodiment, the magnetic sensing circuits each include a constant-current circuit and a buffer circuit for voltage detection or a noninverting amplifier circuit, and hence, the switching is implemented using a low impedance signal. This prevents a reduction in response speed or noise contamination due to an increase in stray capacitance.

In the electronic compass according to this embodiment, when the magnetic sensing circuits are constructed using an analog detection system, magnetic field sensing is continuously performed among the axes, showing good responsiveness. In contrast, when the magnetic sensing circuits are constructed using a digital detection system, one magnetic sensing circuit may be shared among the axes, resulting in reduction in size and power consumption.

The present invention is not limited to the first to third embodiments described above, and various modifications can be made. For example, the circuit structure and procedures in the first and second embodiments are only exemplary, and various modifications can be made without departing from the scope of the present invention.

### Brief Description of the Drawings

[Fig. 1] Fig. 1 is a block diagram showing the schematic structure of a magnetic sensing device according to a first embodiment of the present invention.
[Fig. 2] Fig. 2 is a flowchart describing the sensing operation of the magnetic sensing device according to the first embodiment of the present invention.
[Fig. 3] Fig. 3 is a characteristic diagram for describing the characteristics of a magnetoresistive element.
[Fig. 4] Fig. 4 is a block diagram showing the schematic structure of a magnetic sensing device according to a second embodiment of the present invention.
[Fig. 5] Fig. 5 is a block diagram showing the schematic structure of an electronic compass using the magnetic sensing device according to the present invention. Reference Numerals

- 11: magnetic sensor
- 12: power supply
- 13: voltage detector
- 14: amplitude determining unit
- 15: peak detector
- 16: magnetic field canceller
- 17: amplitude controller
- 18: current amplifier
- 19: constant-current circuit
- 20: output unit
- 31: magnetic sensing device
- 32: processor
- 111: MR element(s)
- 112: coil
- 134: offset voltage detector
- 136: average detector
- 311 to 313: magnetic sensing circuits
- 321 to 323: data storage units
- 324: azimuth calculator

## Claims

1. A magnetic sensing device comprising a magnetic sensor that detects a magnetic-field from a change in resistance; magnetic field generating means for applying an AC magnetic field to the magnetic sensor; determining means for determining, on the basis of an output voltage corresponding to the applied AC magnetic field, whether the magnetic field is outside a sensing range of the magnetic sensor; amplitude controlling means for controlling the amplitude of the AC magnetic field when the magnetic field is not within the sensing range of the magnetic sensor; magnetic field canceling means for supplying a DC current for canceling out an external magnetic field to be sensed, which is superimposed on the magnetic sensor, to the magnetic field generating means; and output means for obtaining the strength of the external magnetic field from the DC current value and outputting the strength.

2. The magnetic sensing device according to Claim 1, wherein the magnetic field generating means includes a coil, the AC magnetic field is applied to the magnetic sensor by supplying current to the coil, and the amplitude controlling means controls the amplitude of the AC magnetic field by changing a current deviation of the current supplied to the coil.

3. The magnetic sensing device according to Claim 2, wherein the determining means performs determination using a first voltage obtained when a specific current is supplied to the coil, a second voltage obtained when a current obtained by subtracting the current deviation from the specific current is supplied to the coil, and a third voltage obtained when a current obtained by-adding the current deviation to the specific current is supplied to the coil.

4. The magnetic sensing device according to Claim 3, wherein the determining means determines that the magnetic field is outside the sensing range of the magnetic sensor when the first to third voltages are approximately equal.

5. The magnetic sensing device according to Claim 3 or Claim 4, wherein the magnetic field canceling means determines that the magnetic field is cancelled out when the first voltage is greater than the second and third voltages, and when the second voltage and the third voltage are approximately equal.

6. The magnetic sensing device according to any one of Claims 1 to 5, wherein the magnetic sensor is a magnetoresistive element that exhibits symmetrical changes in resistance with respect to a magnetic field.

7. The magnetic sensing device according to any one of Claims 1 to 6, wherein the magnetic sensor is a single magnetoresistive element.

8. The magnetic sensing device according to Claim 7, further comprising a constant-current circuit that supplies α-current having a predetermined preset value to the magnetoresistive element, and current-preset-value controlling means for controlling the preset value so that a terminal voltage of the magnetoresistive element is approximately constant.

9. The magnetic sensing device according to any one of Claims 6 to 8, wherein the magnetoresistive element is a GIG element or an MR element.

10. An electronic compass comprising a plurality of magnetic sensing devices as set forth in any one of Claims 1 to 9, and azimuth calculating means for obtaining an azimuth using output values obtained by the plurality of magnetic sensing devices.
